(19) Europäisches Patentamt
European Patent Office
Office européen des brevets

(11) **EP 1 861 521 B1**

(12) **FASCICULE DE BREVET EUROPEEN**

(45) Date de publication et mention
de la délivrance du brevet:
**24.07.2019 Bulletin 2019/30**

(21) Numéro de dépôt: **06726006.7**

(22) Date de dépôt: **02.03.2006**

(51) Int Cl.:
***C23C 22/78*** *(2006.01)*

(86) Numéro de dépôt international:
**PCT/FR2006/000466**

(87) Numéro de publication internationale:
**WO 2006/097593 (21.09.2006 Gazette 2006/38)**

(54) **PROCEDE DE FABRICATION D'UNE PIECE D'ACIER REVETU PRESENTANT UNE TRES HAUTE RESISTANCE APRES TRAITEMENT THERMIQUE**

VERFAHREN ZUR HERSTELLUNG EINES BESCHICHTENTEN STAHLSTÜCKES MIT EINER HOCHBESTÄNDIGKEIT NACH DER THERMISCHEN BEHANDLUNG

METHOD FOR MAKING A COATED STEEL PART HAVING VERY HIGH RESISTANCE AFTER HEAT TREATMENT

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **11.03.2005 FR 0502404**

(43) Date de publication de la demande:
**05.12.2007 Bulletin 2007/49**

(73) Titulaire: **ArcelorMittal**
**1160 Luxembourg (LU)**

(72) Inventeurs:
• **LAURENT, Jean-Pierre**
**13800 Istres (FR)**
• **DEVROC, Jacques**
**13200 Arles (FR)**

(74) Mandataire: **Lavoix et al**
**2, place d'Estienne d'Orves**
**75441 Paris Cedex 09 (FR)**

(56) Documents cités:
| EP-A- 1 013 785 | EP-A- 1 403 388 |
| WO-A- 99/55469 | DE-A1- 10 224 319 |
| DE-B- 1 290 024 | FR-A- 857 779 |
| GB-A- 1 489 618 | US-A- 3 214 820 |
| US-B1- 6 197 132 | US-B1- 6 296 805 |

**Description**

L'invention concerne la fabrication de pièces d'acier revêtu laminé à chaud ou à froid, présentant une haute résistance mécanique ainsi qu'une bonne résistance à la corrosion.

Pour certaines applications, on cherche à réaliser des pièces en acier combinant une résistance mécanique élevée, une grande résistance aux chocs et une bonne tenue à la corrosion. Ce type de combinaison est particulièrement désirable dans l'industrie automobile où l'on recherche un allègement significatif des véhicules. Ceci peut être notamment obtenu grâce à l'utilisation d'aciers à très hautes caractéristiques mécaniques : Des pièces anti-intrusion, de structure ou de sécurité des véhicules automobiles (traverses de pare-choc, renforts de portière ou de pied milieu, bras de roue) nécessitent par exemple les qualités évoquées plus haut.

Le brevet FR 2807447 divulgue un procédé de fabrication où on approvisionne une tôle d'acier de base avec un pré-revêtement métallique, l'acier possédant une résistance à la rupture de l'ordre de 500MPa, on procède à une opération de mise en forme à froid, par exemple d'emboutissage ou de profilage à froid, puis l'on effectue un traitement thermique en vue d'une trempe ultérieure au sein d'un outillage de forme adapté à la géométrie de la pièce. Durant la phase de chauffage de ce traitement thermique, on forme un revêtement intermétallique à la surface de la pièce par alliation du pré-revêtement initial et de l'acier de base. De la sorte, on obtient par exemple des pièces avec une résistance mécanique supérieure à 1500MPa offrant une résistance à la corrosion. Chacun des brevets US 6 197 132 B1 ou US 6 296 805 B1 décrit un procédé de fabrication d'une pièce d'acier revêtue présentant une très haute résistance après un traitement thermique à partir d'une bande d'acier, laminée à chaud et à froid et pré-revêtue avec un revêtement métallique à base d'aluminium.

La tôle d'acier de base peut être prérevêtue d'aluminium ou d'un alliage d'aluminium par un procédé au trempé. On peut cependant rencontrer des limitations à la mise en oeuvre de ce procédé dans certains cas . Lors d'opérations de mise en forme à froid de la pièce avant traitement thermique, certaines zones peuvent être soumises à une déformation plus sévère, et l'on peut éventuellement assister à un endommagement de l'interface entre le substrat et le pré-revêtement, sous forme de décohésion locale. Dans ce cas, le traitement thermique ultérieur peut conduire à la formation de calamine au voisinage de la couche interfaciale d'alliage. La présence de cette calamine est néfaste à la réalisation d'une alliation satisfaisante entre l'acier de base et le pré-revêtement aluminié.

Par ailleurs, après mise en forme à froid des pièces aluminiées, on peut effectuer une découpe, un poinçonnage ou un détourage en vue d'enlever l'excédent de matière avant le traitement thermique ultérieur d'alliation. La présence du pré-revêtement aluminié au trempé peut contribuer à l'usure de l'outillage de découpe.

D'autre part, le pré-revêtement des tôles aluminiées au trempé peut présenter une variation d'épaisseur par rapport à l'épaisseur nominale. Le chauffage lors du traitement thermique d'alliation est effectué assez rapidement, typiquement en quelques minutes. En cas de surépaisseur excessive, on assiste à une alliation incomplète du revêtement. La température de fusion des pré-revêtements usuels étant de 660°C pour l'aluminium ou de 580°C pour un alliage aluminium-10% silicium, on pourra assister à une fusion prématurée du côté le plus épais du revêtement avant d'atteindre la température d'austénitisation de la pièce. Les traitements thermiques étant effectués généralement dans des fours où les pièces sont déplacées sur des rouleaux, la surface de ces derniers est polluée d'une couche provenant de la fusion partielle du pré-revêtement, ce qui nuit à la bonne marche des fours. En outre, une alliation incomplète du pré-revêtement est néfaste lors d'opérations ultérieures de cataphorèse

La présente invention a pour but de résoudre les problèmes évoqués ci-dessus. Elle vise en particulier à mettre à disposition un procédé de fabrication de pièces d'acier laminées à chaud ou à froid pré-revêtues d'aluminium ou d'alliage d'aluminium, permettant une déformation importante préalable à froid avant traitement d'alliation sans risque de conséquence ultérieure sur le traitement d'alliation. Elle vise à réduire l'usure de l'outillage lors de l'usinage mécanique avant le traitement thermique d'alliation. Elle vise également à obtenir, après traitement thermique, une alliation complète du pré-revêtement d'aluminium ou d'alliage d'aluminium.

Dans ce but, l'invention a pour objet un procédé de fabrication d'une pièce à très hautes caractéristiques mécaniques à partir d'une bande d'acier, laminée à chaud ou à froid, comportant les étapes successives suivantes :

- On effectue un pré-revêtement de la bande par de l'aluminium ou d'un alliage d'aluminium. Ce pré-revêtement peut être réalisé par une ou plusieurs étapes selon les modes ci-dessous, seuls ou en combinaison :

    - pré-revêtement par une ou plusieurs étapes d'électrodéposition d'aluminium ou d'alliage d'aluminium
    - pré-revêtement par une ou plusieurs étapes de dépôt chimique en phase vapeur d'aluminium ou d'alliage d'aluminium
    - pré-revêtement par une ou plusieurs étapes de dépôt physique en phase vapeur d'aluminium ou d'alliage d'aluminium.
    - pré-revêtement par une ou plusieurs étapes de colaminage entre la bande d'acier et un feuillard d'aluminium ou d'alliage d'aluminium.
    - Grâce à la mise en oeuvre de ces modes de pré-revêtement, l'interface entre la bande d'acier et le pré-revêtement ne comporte pas de phase intermétallique.

- On déforme à froid la bande revêtue
- On retire éventuellement les excédents de tôle en vue de la géométrie finale de ladite pièce
- On chauffe la pièce, par exemple au sein d'un four, de façon à réaliser un composé intermétallique à la surface de la pièce, à partir de l'interface acier-revêtement et à austénitiser l'acier. Durant la phase de chauffage de ce traitement thermique, on forme, par alliation de la couche de pré-revêtement initial et de l'acier de base, un revêtement intermétallique à la surface de la pièce, cette alliation étant réalisée dans la totalité de l'épaisseur de la couche de revêtement.
- Après chauffage, on transfère la pièce au sein d'un outillage. Le temps de transfert entre la phase de chauffage et le contact avec l'outillage est suffisamment court pour qu'une transformation de l'austénite n'intervienne pas durant ce laps de temps. La géométrie et la conception de l'outillage sont adaptées à la pièce à traiter et à la drasticité de la trempe. En particulier, ces outils peuvent être refroidis, notamment par circulation de fluide pour augmenter la productivité des opérations et/ou accroître la sévérité de trempe. Un effort de serrage peut assurer un contact intime entre les pièces et l'outillage, permettant ainsi un refroidissement efficace par conduction et une déformation minimale. On refroidit la pièce au sein de l'outillage avec une vitesse telle que la structure de l'acier après refroidissement soit martensitique, ou bainitique ou martensito-bainitique.

Selon le procédé de la revendication 1 le taux de la déformation généralisée de la déformation à froid est supérieur à 20% en au moins un point de la pièce.

L'invention a également pour objet l'utilisation d'une pièce à très hautes caractéristiques mécaniques à partir d'une bande d'acier, fabriquée selon l'un des modes ci-dessus, pour la fabrication de pièces de structures ou de sécurité pour véhicule automobile terrestre à moteur.

D'autres caractéristiques et avantages de l'invention apparaîtront au cours de la description ci-dessous, donnée à titre d'exemple.

La figure 1 présente un exemple d'interface acier-alliage d'aluminium déposé au trempé, avant déformation à froid

La figure 2 présente l'évolution de cette interface après déformation généralisée à froid supérieure à 20%.

La figure 3 présente un exemple d'interface acier-alliage d'aluminium déposé au trempé, sans déformation à froid, après traitement d'alliation.

La figure 4 illustre la couche superficielle après déformation à froid supérieure à 20%, suivie par un traitement d'alliation.

On a examiné l'évolution de l'interface acier-revêtement au cours d'un procédé de fabrication conventionnel : dans ce but, on a considéré des pièces d'acier de 1,2 ou 2mm d'épaisseur, de composition pondérale suivante :

Carbone : 0,15 à 0,25%
Manganèse : 0,8 à 1,5%
Silicium : 0,1 à 0,35%
Chrome : 0,01 à 0,2%
Titane < 0,1%
Phosphore< 0,05%
Soufre <0,03%
B : 0,0005% à 0,01%,

Celles-ci ont été pré-revêtues grâce à un procédé conventionnel au trempé dans un bain à base d'aluminium comportant :

Silicium : 9-10%
Fer : 2 à 3,5%
Le solde étant constitué d'aluminium et des inévitables impuretés

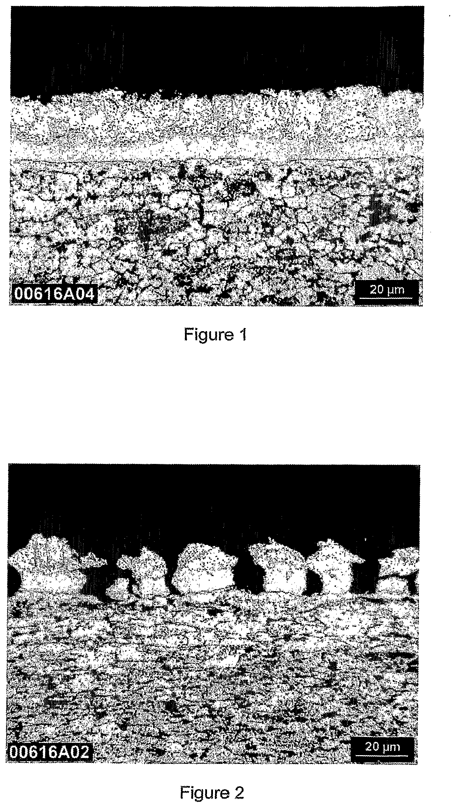

Il est connu que le contact d'un acier dans un bain d'aluminium pur à plus de 660°C conduit à une formation très rapide d'une épaisse couche d'alliage intermétallique, comportant notamment FeAl3-Fe2Al5. Cette couche présentant une faible aptitude à la déformation, une addition de 10% de silicium dans le bain permet de réduire l'épaisseur de cette couche intermédiaire. La figure 1 indique que la couche intermétallique, d'une dureté de 600 à 800HV, a une épaisseur d'environ 7 micromètres, celle-ci étant surmontée par une couche métallique à base d'aluminium de 15 micromètres environ.

Les pièces pré-revêtues ont été soumises à une déformation à froid sur éprouvettes de type Nakazima, sollicitant celles-ci selon différents modes : traction uniaxiale, expansion équibiaxiale. Au moyen de grilles à motifs circulaires préalablement photodéposées, on a mesuré en divers points les déformations principales $\varepsilon_1$, $\varepsilon_2$, c'est à dire les déformations dans un repère principal. On en déduit la déformation généralisée :

$$\bar{\varepsilon} = \frac{2}{\sqrt{3}}\sqrt{(\varepsilon_1^2 + \varepsilon_1\varepsilon_2 + \varepsilon_2^2)}$$

relative à ces différents points.

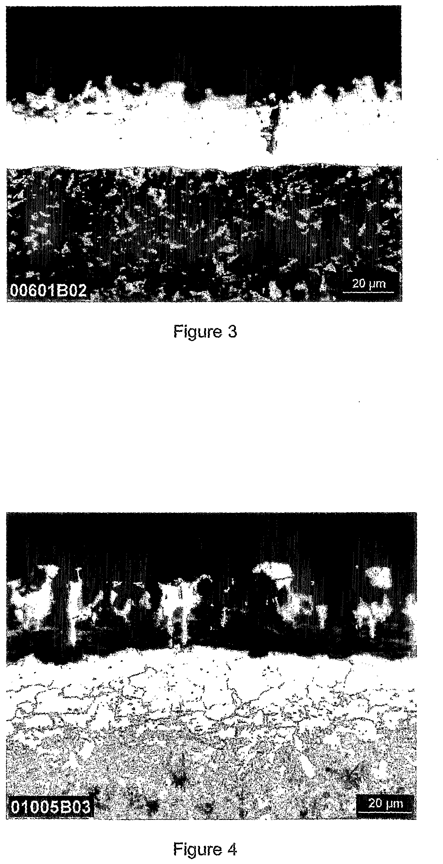

Simultanément, on a observé en ces différents emplacements le comportement du pré-revêtement : Les observations révèlent que, jusqu'à une déformation généralisée de l'ordre de 10%, la couche intermédiaire est fissurée de manière fine et régulière, sans conséquence sur la couche supérieure d'aluminium métallique surmontant celle-ci. Un traitement thermique ultérieur en four à 900°C pendant 5 ou 7 minutes, suivi d'une trempe au sein d'un outillage refroidi à l'eau conduit à une alliation complète du revêtement initial et à la disparition de ce réseau limité de fissures (figure 3). Au-delà de 20% de déformation généralisée, on assiste à une fragmentation de la couche intermétallique (figure 2), et par endroits, à une dégradation du revêtement métallique à base d'aluminium. Le traitement thermique ultérieur d'alliation peut alors provoquer la croissance d'une couche de calamine ou une décarburation à la surface de l'acier (figure 4) néfaste à la mise en oeuvre ultérieure de la pièce, par exemple à une mise en peinture

Ainsi, la mise en oeuvre d'un procédé de déformation à froid avec une déformation sévère peut conduire à des difficultés à partir d'un pré-revêtement conventionnel à base d'aluminium. Dans le cadre de l'invention, on a mis en évidence que ce problème était résolu lorsque l'interface entre l'acier et l'aluminium ne comportait pas de phase intermétallique. En effet, compte tenu de la ductilité intrinsèque de l'aluminium ou de l'alliage d'aluminium, liée à sa structure cubique-face-centrée, une déformation à froid importante d'un acier pré-revêtu ne conduit à aucune dégradation de l'interface ou du pré-revêtement, si bien que le traitement d'alliation ultérieur intervient dans des conditions optimales.

Le pré-revêtement d'aluminium ou d'un alliage d'aluminium est réalisé par électrodéposition, par dépôt physique ou chimique en phase vapeur, ou encore par colaminage entre une bande d'acier et un feuillard d'aluminium ou d'alliage d'aluminium. Par ces différentes étapes, on aboutit ainsi à une pièce sans couche intermétallique entre l'acier de base et le pré-revêtement avant le traitement d'alliation. Le procédé selon l'invention peut être mis en oeuvre en appliquant une même étape de pré-revêtement en une seule reprise, ou en appliquant celui-ci à plusieurs reprises. De même, le procédé peut être mis en oeuvre selon l'invention en combinant successivement différentes étapes de pré-revêtements de façon à exploiter les avantages intrinsèques aux différents procédés et aux différentes caractéristiques des dépôts.

L'application du procédé selon l'invention facilite la mise en oeuvre dans le cas d'un découpage, d'un poinçonnage ou d'un détourage des pièces après l'opération de mise en forme à froid. En effet, un usinage intermédiaire peut s'avérer utile dans le but de diminuer le volume de métal à réchauffer dans le traitement d'alliation. Selon l'invention, cet usinage intermédiaire est facilité par l'absence de la couche intermétallique dure (de 600 à 800 HV) que l'on rencontre dans le procédé conventionnel. De la sorte, l'usure des outils de découpe est réduité.

Par ailleurs, les étapes de pré-revêtement selon l'invention sont associées à des dépôts d'une grande régularité d'épaisseur : par exemple, les conditions de pré-revêtement en phase vapeur peuvent être associées à un dépôt d'épaisseur compris entre 15 et 20 micromètres avec une variation d'épaisseur d'ordre micrométrique.

Selon les procédés d'aluminiage au trempé, la variation d'épaisseur du pré-revêtement mesurée sur coupe micrographique peut être de l'ordre de ±10 micromètres pour une épaisseur moyenne de 25 micromètres. Dans le but de maximiser la productivité, on souhaite que le chauffage lors du traitement thermique d'alliation s'effectue le plus rapidement possible. La constatation de la présence d'une surépaisseur peut conduire à allonger la phase de chauffage, pour que l'alliation soit complète. Pour un traitement thermique donné, la méconnaissance d'une surépaisseur excessive peut avoir pour conséquence une alliation incomplète, se traduisant par une fusion partielle du pré-revêtement.

L'étape de pré-revêtement selon l'invention conduit à une faible variabilité de l'épaisseur, ce qui diminue le risque de fusion et augmente la stabilité de la marche des fours.

Par ailleurs, après austénitisation, le traitement de trempe par refroidissement au sein d'un outillage confère une structure martensitique ou bainitique ou martensito-bainitique à l'acier. Selon la composition de l'acier, en particulier sa teneur en carbone, ainsi qu'en manganèse, chrome et bore, la résistance maximale obtenue sur les pièces selon l'invention, varie de 1200 à 1700MPa. Selon l'invention, la coupe s'effectuant de manière plus nette en raison de l'absence de couche intermétallique, l'effet d'entaille en bord de découpe est moindre après traitement de trempe, puisque l'on sait que des structures totalement ou partiellement martensitiques sont par essence plus sensibles aux effets de concentrations locales de contraintes.

Ainsi, l'invention permet la fabrication de pièces à hautes caractéristiques revêtues, avec des formes plus complexes, puisque la déformation à froid peut atteindre des taux importants. L'invention est mise en oeuvre de façon particulièrement avantageuse lorsque le taux de la déformation généralisée à froid préalable au traitement d'alliation est supérieur à 20%. Elle permet une réduction de l'usure de l'outillage lors des opérations intermédiaires de découpe et conduit à une plus grande efficacité du traitement final d'alliation.

## Revendications

1. Procédé de fabrication d'une pièce à très hautes caractéristiques mécaniques à partir d'une bande d'acier, laminée à chaud ou à froid, comportant les étapes successives suivantes :

   - On effectue un pré-revêtement de ladite bande par de l'aluminium ou un alliage d'aluminium
   - On déforme à froid ladite bande revêtue
   - On retire éventuellement les excédents de tôle en vue de la géométrie finale de ladite pièce
   - On chauffe ladite pièce de façon à réaliser un composé intermétallique à la surface de ladite pièce à partir de l'interface acier-revêtement et à austénitiser l'acier

- On transfère ladite pièce au sein d'un outillage
- On refroidit ladite pièce au sein d'un outillage avec une vitesse telle que la structure de l'acier après refroidissement soit martensitique ou bainitique ou martensito-bainitique,
- **caractérisé en ce que** l'interface entre ladite bande d'acier et le pré-revêtement avant ledit chauffage ne comporte pas de phase intermétallique et que l'on réalise ledit pré-revêtement par au moins une étape d'électrodéposition d'aluminium ou d'alliage d'aluminium, par au moins une étape de dépôt chimique en phase vapeur d'aluminium ou d'alliage d'aluminium, par au moins une étape de dépôt physique en phase vapeur d'aluminium ou d'alliage d'aluminium, par au moins une étape de colaminage entre ladite bande d'acier et un feuillard d'aluminium ou d'alliage d'aluminium, lesdites au moins une étape de pré-revêtement pouvant être réalisées seules ou en combinaison,
- et **en ce que** le taux de la déformation généralisée de ladite déformation à froid est supérieur à 20% en au moins un point de ladite pièce, le taux de déformation généralisée étant défini par

$$\bar{\varepsilon} = \frac{2}{\sqrt{3}}\sqrt{(\varepsilon_1^2 + \varepsilon_1\varepsilon_2 + \varepsilon_2^2)},$$

$\varepsilon_1$, $\varepsilon_2$ étant les déformations principales associées à ladite déformation à froid.

2. Procédé de fabrication selon la revendication 1, dans lequel la pièce présente une résistance mécanique comprise entre 1200 et 1700 MPa.

3. Utilisation d'une pièce à très hautes caractéristiques mécaniques à partir d'une bande d'acier fabriquée selon la revendication 1 ou 2, pour la fabrication de pièces de structures ou de sécurité pour véhicule automobile terrestre à moteur.

## Patentansprüche

1. Verfahren zur Herstellung eines Bauteils mit sehr hohen mechanischen Eigenschaften aus einem Stahlband, das warm- oder kaltgewalzt ist, aufweisend die nachfolgenden sukzessiven Schritte:

   - Durchführen eines Vorbeschichtens des besagten Bands mit Aluminium oder einer Aluminiumlegierung,
   - Kaltverformen des besagten beschichteten Bands,
   - Eventuelles Wegnehmen der Blechüberschüsse hinsichtlich der Endgeometrie des besagten Bauteils,
   - Erwärmen des besagten Bauteils, um eine intermetallische Verbindung an der Oberfläche des besagten Bauteils aus der Schnittstelle Stahl-Beschichtung zu realisieren und um den Stahl zu austenitisieren,
   - Transferieren des besagten Bauteils in einem Werkzeug,
   - Abkühlen des besagten Bauteils in einem Werkzeug mit einer Geschwindigkeit, sodass die Struktur des Stahls nach dem Abkühlen entweder martensitisch oder bainitisch oder martensitisch-bainitisch ist,
   - **gekennzeichnet dadurch, dass** die Schnittstelle zwischen dem besagten Stahlband und der Vorbeschichtung vor dem besagten Erwärmen keine intermetallische Phase aufweist und dass die besagte Vorbeschichtung realisiert wird durch zumindest einen Schritt des galvanischen Beschichtens mit Aluminium oder einer Aluminiumlegierung, durch zumindest einen Schritt des chemischen Gasphasen-Abscheidens von Aluminium oder einer Aluminiumlegierung, durch zumindest einen Schritt des physikalischen Gasphasen-Abscheidens von Aluminium oder einer Aluminiumlegierung, durch zumindest einen Schritt des Zusammenwalzens zwischen dem besagten Stahlband und einem Band aus Aluminium oder aus einer Aluminiumlegierung, wobei die besagten zumindest ein Schritt des Vorbeschichtens allein oder in Kombination realisiert werden können,
   - und dadurch, dass die Quote der Deformation, die von der Kaltdeformation erzeugt wird, zumindest an einer Stelle des besagten Bauteils größer als 20% ist, wobei die Quote der erzeugten Deformation definiert ist durch

$$\bar{\varepsilon} = \frac{2}{\sqrt{3}}\sqrt{\left(\varepsilon_1^2 + \varepsilon_1\varepsilon_2 + \varepsilon_2^2\right)},$$

wobei $\varepsilon_1$, $\varepsilon_2$ Hauptverformungen sind, die mit der besagten Kaltverformung zusammenhängen.

2. Verfahren zur Herstellung gemäß Anspruch 1, wobei das Bauteil eine mechanische Festigkeit hat, die zwischen 1200 und 1700 MPa liegt.

3. Verwendung eines Bauteils mit sehr hohen mechanischen Eigenschaften aus einem Stahlband, hergestellt gemäß Anspruch 1 oder 2, für die Herstellung von Struktur- oder Sicherheitsbauteilen für ein motorangetriebenes Land-Kraftfahrzeug.

## Claims

1. Method for manufacturing a part having very high mechanical properties from a hot-rolled or cold-rolled steel strip, comprising the following successive steps:

- said strip is precoated with aluminium or an aluminium alloy;
- said coated strip is cold-deformed;
- any excess sheet is removed, in view of the final geometry of said part;
- said part is heated so as to form an intermetallic compound on the surface of said part, starting from the steel/coating interface, and to austenitise the steel;
- said part is transferred to a tool;
- said part is cooled in a tool at a rate such that the steel has, after being cooled, a martensitic or bainitic structure or a martensite-bainite structure;
- **characterised in that** the interface between said steel strip and the precoat before said heating has no intermetallic phase and **in that** said precoat is formed by at least one aluminium or aluminium alloy electroplating step, by at least one aluminium or aluminium alloy chemical vapour deposition step, by at least one aluminium or aluminium alloy physical vapour deposition step, by at least one co-rolling step in which said steel strip is co-rolled with an aluminium or aluminium alloy foil, it being possible for said at least one precoating step to be carried out by itself or in combination,
- and **in that** the generalised strain of said cold deformation is greater than 20% at at least one point of said part, the generalised strain being defined by $\overline{\varepsilon} = \frac{2}{\sqrt{3}} \sqrt{(\varepsilon_1^2 + \varepsilon_1 \varepsilon_2 + \varepsilon_2^2)}$, $\varepsilon_1, \varepsilon_2$ being the principal strains associated with said cold deformation.

2. Manufacturing method according to claim 1, wherein the part has a mechanical strength of between 1200 and 1700 MPa.

3. Use of a part having very high mechanical properties obtained from a steel strip manufactured according to claim 1 or 2, in the manufacture of structural or safety parts for land motor vehicles.

Figure 1

Figure 2

Figure 3

Figure 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2807447
- US 6197132 B1

- US 6296805 B1